Europäisches Patentamt

European Patent Office

Office européen des brevets

(11) Publication number: **0 214 914 B1**

(12) **EUROPEAN PATENT SPECIFICATION**

(45) Date of publication of patent specification: **04.12.91**  (51) Int. Cl.5: **G11C 29/00**

(21) Application number: **86401968.2**

(22) Date of filing: **09.09.86**

(54) Test method for detecting faulty memory cells in a programmable semiconductor device.

(30) Priority: **09.09.85 JP 198761/85**

(43) Date of publication of application:
**18.03.87 Bulletin 87/12**

(45) Publication of the grant of the patent:
**04.12.91 Bulletin 91/49**

(84) Designated Contracting States:
**DE FR GB**

(56) References cited:
**EP-A- 0 032 015
EP-A- 0 146 975
DE-A- 2 516 973
US-A- 3 679 970**

**IEEE JOURNAL OF SOLID-STATE CIRCUITS,
vol. SC-19, no. 2, April 1984, pages 187-194;
T. FUKUSHIMA et al.: "A 40 ns 64 kbit
junction-shorting PROM"**

**PATENT ABSTRACTS OF JAPAN, vol. 7, no.
42 (P-177)[1187], 19th February 1983; & JP-
A-57 191 900 (HITACHI SEISAKUSHO K.K.)
25-11-1982**

(73) Proprietor: **FUJITSU LIMITED
1015, Kamikodanaka Nakahara-ku
Kawasaki-shi Kanagawa 211(JP)**

(72) Inventor: **Fukushima, Toshitaka
1604-442, Shiomidai Isogo-ku
Yokohama-shi Kanagawa 225(JP)**

(74) Representative: **Descourtieux, Philippe et al
CABINET BEAU de LOMENIE 55 rue
d'Amsterdam
F-75008 Paris(FR)**

Rank Xerox (UK) Business Services

**Description**

The present invention relates to a method for detecting a faulty memory cell of a programmable semiconductor device. More particularly, the present invention relates to a method for detecting a delayed access time caused by the degraded isolation resistance of an unprogrammed cell.

Very many programmable read only memories made by using a semiconductor technology (referred to hereinafter as PROM) have been widely used in the electronic industry. They can be classified by the type of the memory cells, such as a fuse-blown type, a junction-shortening type and an insulator-shortening type. The fuse-blown PROM is that in which the write-in operation is carried out by applying a high current therein to blow the fuse. The junction-shortening PROM, so-called diode type, is that in which the write-in operation is carried out by applying a high current therein to shorten the reverse p-n junction diode. The insulator-shortening PROM, so called condenser type, is that in which the write-in operation is carried out by applying a higher voltage than its break-down voltage to shorten the insulator made of, for example, a silicon dioxide, in place of the above-mentioned p-n junction diode.

As a representative prior art which supports the explanation of the present invention, a PROM of the p-n junction type shall hereinafter be described in detail. A general concept of a modern PROM of junction-shortening type is also described by the inventor et al. in a paper "A 40 ns 64 Kbit Junction-Shortening PROM", IEEE JOURNAL OF SOLID-STATE CIRCUITS, Vol sc-19, No.2, Apr. 1984.

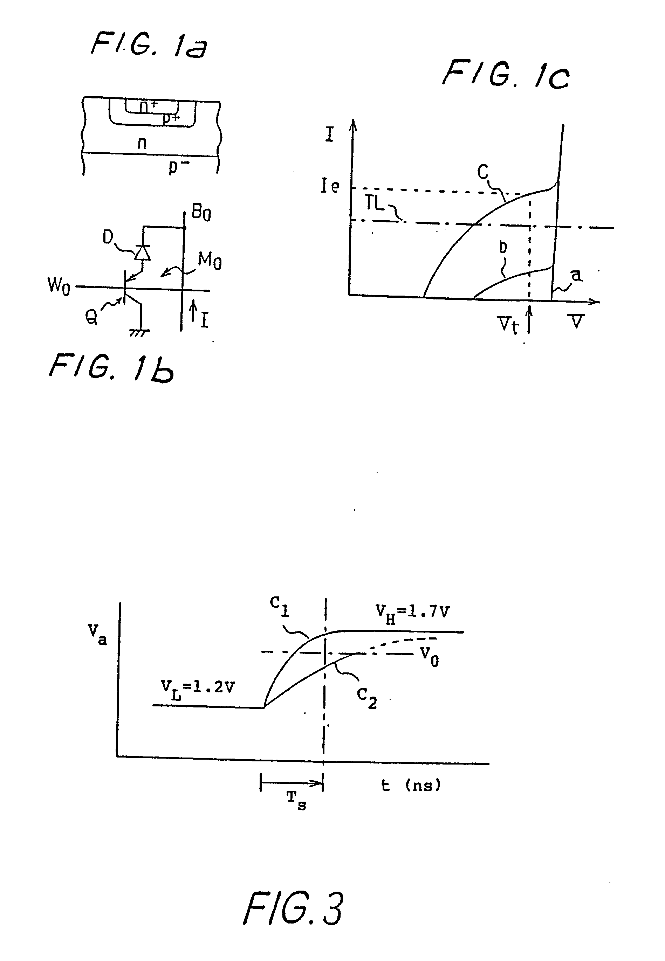

Fig.1a schematically illustrates a vertically cross sectional view of a memory cell of the junction-shortening type and Fig.1b shows the equivalent circuit of the cell $M_0$. A diode D, as a programmable element, and a reverse current stopper element Q operatively connected in series are composing the memory cell $M_0$.

The diode D is connected in a direction to block the current flow from the bit line. The reverse-current stopper O is a p-n-p transistor connected in a direction to allow a current to flow from the bit line therethrough and through the diode D. This stopper element Q can be a diode; however, the description shall be given only for the case using a transistor, because the stopper element is not directly concerned with the present invention. As shown in Fig. 1a, the diode D is composed of $n^+$ and $p^+$ diffusion layers fabricated by carrying out an ordinary n-p-n transistor technology. The p-n-p transistor Q consists of the $p^+$ diffusion layer, which is common to the p-n junction diode, an n-epitaxial layer, and a $p^-$ substrate. An aluminium electrode (not shown in Fig.1a) is provided as a bit line $B_0$ on the $n^+$ layer which is the cathode of the diode D. The common base of the transistor Q acts as a word line $W_0$.

The memory cell $M_0$ is addressed, namely selected, by applying high level (referred to hereinafter as H) on the bit line $B_0$ as well as low level (referred to hereinafter as L) on the word line $W_0$. For programming, namely writing-in an addressed cell, current pulses of 125 mA and 11μs are applied to the addressed cell through the bit line. This high current not only breaks down the reversely connected diode but also increases the temperature of the junction to result in its shortening. As for reading-out the cell, when a cell us addressed, and if the diode D has been previously shortened, namely programmed (referred to hereinafter as written-in), a current flows from $B_0$ through D and Q to the ground. If the diode D is non-conductive, namely not programmed (referred to hereinafter as unwritten-in), the above-mentioned current does not flow. Thus, the memorized datum in the cell, "1" or "0", can be read-out by sensing the existence of this current flow.

In Fig. 1c, there is shown the voltage-current characteristic between $B_0$ and $W_0$ of an addressed unwritten-in memory cell. This characteristic is dominantly affected by the degradation of the reverse diode D by its leakage, because the transistor Q is conductive. The ideal characteristic of a memory cell is shown by the curve (a), where the current is almost zero as far as the applied voltage is below the breakdown voltage of normal 6 to 7 volt, and sharply increases when the applied voltage exceeds the breakdown voltage. This breakdown is caused by the Zener-breakdown of the reverse diode D. The curve (b) and (c) show the characteristics of degraded memory cells each having so-called soft breakdown. The leakage is normally caused by lattice defects at the surface or abnormal diffusion. When this current leakage is large or the breakdown voltage is low, it is difficult to distinguish this leaky cell from a written-in cell and, in the worst case, this results in an error of reading-out. Therefore, the leakage below a specified voltage of the reverse diodes must be tested and rejected at the production stage of the PROM.

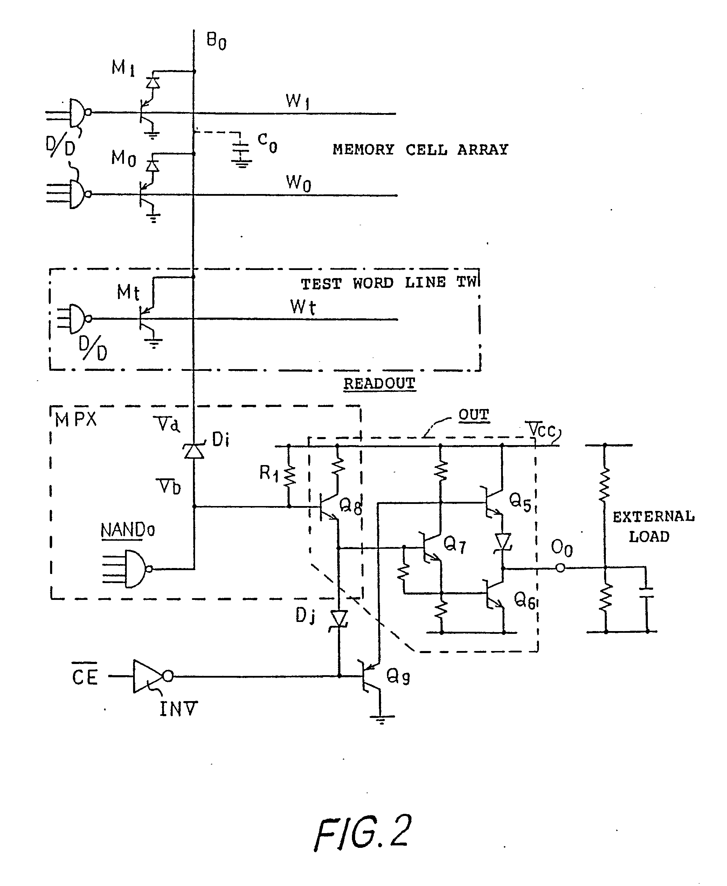

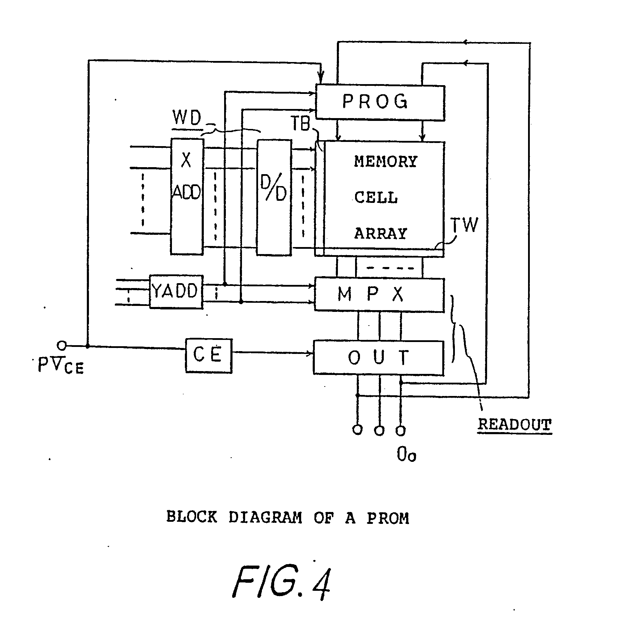

Another problem caused by this leakage of the unwritten-in diode is concerned with the access time, the delay time for reading-out. A leaky unwritten-in cell has a longer access time than that of the normal cell. The mechanism of this delay, the longer access time, is as follows. Before a bit line is addressed, the voltage level of the bit line $B_0$ is L. At the moment at which the bit line is addressed, the bit line voltage starts to rise up to the H level, receiving a current from a power voltage source $V_{cc}$ through a fixed resistor $R_1$ as shown in Fig.2. However, each bit line is destined to have a stray capacity $C_0$ parallel to the cell, and, because of the time constant of the charging resistor $R_1$ and the stray capacity $C_0$, the voltage rise on the bit line is gradual as shown by the curve $C_1$ in Fig. 3. Then, if the cell has a leakage, the charging current into the capacity is reduced by the amount of the leakage and also the charge in the capacity is lost through this leakage. Accordingly, not only the voltage at a steady state is lower than that of a normal cell, but also the speed of the voltage rise is slower as shown by the curve $C_2$ compared with the curve $C_1$ relative to a normal cell. The access operation of a memory cell is completed when the bit line reaches the threshold level, and the output level of the output buffer is changed. Thus, a leaky cell results in more delay of completion of access operation than that of the normal cell.

When the integration of PROMs was not so large and the access time was not so severely required as today, the access delay caused by a small leakage as above-mentioned was not so serious. However, as PROMs become larger in memory capacity, the variation of characteristics of cells becomes larger, and the probability to produce cells having a small leakage as shown by the curve (b) of Fig. 1c is also increasing. Therefore, a method to effectively detect a faulty cell, exhibiting a small leakage must be imperatively established.

In general, in order to discriminate a leaky cell, a DC (direct current) test may be used, where a limiting current level as shown by TL in Fig. 1c is specified. However, the value of TL cannot be reduced as much as required, because the possible lowest value of TL is limited by the peripheral circuit in use.

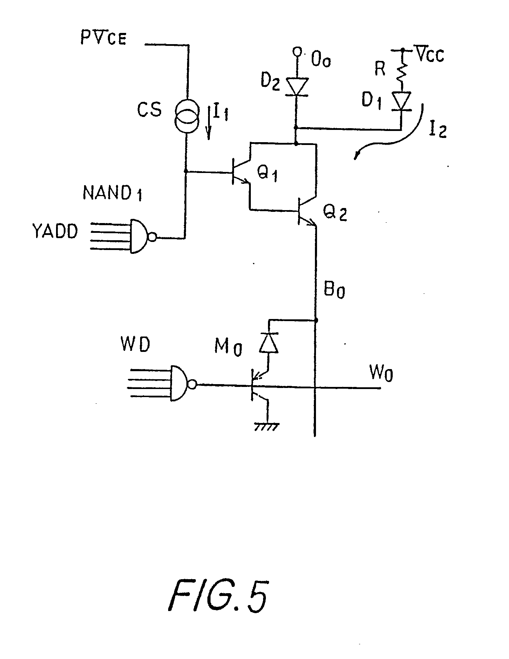

The reason why the detectable lowest leakage current is limited is as follows. The constitution of a typical PROM is shown by the block diagram in Fig. 4. The output terminal $O_0$ is used in three ways, namely for reading-out, writing-in and testing. Testing of a cell is done by applying a voltage on the output terminal $O_0$ in order to inject a current from an external tester, and sensing the current flowing thereinto. There are provided as many output terminals as there are read-out bit lines, but only one terminal $O_0$ is referred to, this being enough to explain the principle of the cell test. PROG shown in Fig. 4 denotes a programming circuit, a circuit for writing-in a cell. A circuit diagram relating to one memory cell of the programming circuit PROG is schematically illustrated in Fig. 5 in detail. Further in Fig. 4, XADD denotes an X-address buffer, and D/D denotes a decoder/driver all of which are equivalent to the word driver WD in Fig.5. YADD denotes a Y-address buffer, which, in case of reading-out, controls the multiplexer $\overline{MPX}$ to select the bit line of the cell to be read-out, as well as in case of writing-in, controls the programming circuit PROG to select the bit line of the cell to be written-in. CE denotes a circuit for enabling, namely activating, the output buffer OUT, at chip-enable state. TW and TB denote respectively a test word line and a test bit line, by each of which test cells are operatively connected to be addressed. These test cells are written-in cells which have been provided in addition to the ordinary memory cells for testing purposes.

The function of the programming circuit PROG, used for testing a cell, is described hereinafter. As shown in Fig. 5, the circuit PROG is composed of transistors $Q_1$, $Q_2$ mutually in Darlington connection, a resistor R, a diode $D_1$ both of which are for pulling up the collectors of these transistors to a power source $V_{cc}$, and a constant-current power source CS. (If the collectors are floated without being pulled-up, a parasitic capacity of the collectors may cause a malfunction of the circuit). The output terminal is operatively connected to the collectors of the Darlington circuit through a diode $D_2$, which prevents a current from flowing towards the outside. In this circuit, when the word line $W_0$ is addressed by the word decoder WD and the bit line $B_0$ is addressed by gate $NAND_1$ which is controlled by the combination of signals in Y-address buffer YADD, the transistors become conductive by a current $I_1$(0.3mA) supplied from the current source CS, thus a current $I_2$ from the power source $V_{cc}$ through the resistor R and the diode $D_1$, together with the current $I_1$, are ready to flow into the bit line $B_0$. The resistor R is of approximately 1 Kohm, for example, so the current $I_2$ is of approximately 2 mA. At this stage, if the addressed cell $M_0$ is conductive, namely previously written-in or having a defectively large leakage, the current $I_1 + I_2$ flows into the bit line $B_0$. If the addressed cell $M_0$ is unwritten-in, this current does not flow thereinto. As previously described, the test of the cell is done by sensing a current flowing into the terminal $O_0$ while injecting a current into this terminal from an external tester. However, if the leakage current of the cell under test is as low as $I_1 + I_2$, no current can flow into the terminal $O_0$, because the current $I_1 + I_2$ is already supplied from other sources. Thus, at the terminal $O_0$ the external tester can only detect a current of more than $I_1 + I_2$. This means that the lowest detectable level of the leakage current of the cell is $TL = I_1 + I_2$. Therefore, if the leakage current is lower than $I_1 + I_2$ the above-described DC method cannot detect a faulty cell whose access time is so long as cannot be disregarded.

It is an object of the present invention to provide a method for detecting and rejecting a faulty unwritten-in PROM cell having an access delay caused by a leakage current which cannot be effectively detected by a DC method.

The method according to the invention is specified in claim 1.

In order to embody the present invention, some specified memory cells of a PROM under test have

3

been previously written-in.

While a readout circuit is enabled, input signals to address a written-in cell are switched so as to address an unwritten-in cell, then a delay of a voltage produced on the bit line of the addressed unwritten-in cell is detected in comparison with the applied addressing pulse. Or while the readout circuit is disabled, input signals to address a written-in cell are switched so as to address an unwritten-in cell, and successively the readout circuit is enabled, and then a delay of a voltage produced on the bit line of the addressed unwritten-in cell is detected in comparison with the application of the enabling signal. A faulty cell is discriminated by the degree of above-mentioned delay, an access delay.

The above-mentioned features and advantages of the present invention, will become more readily apparent from the following description.

Figs.1a, 1b, 1c schematically illustrate a memory cell of a junction-shortening type (as an example of a programmable cell type), an equivalent circuit thereof, and the voltage-current characteristics between bit line and word line of an addressed unwritten-in memory cell.

Fig. 2 shows a readout circuit and the related cells of a PROM on which the present invention can be carried out.

Fig. 3 shows a transient voltage characteristic of an unwritten-in memory cell.

Fig. 4 shows a block diagram of a PROM.

Fig. 5 shows a circuit diagram of a programming circuit for the PROM of Fig. 4.

Fig. 6 shows timing charts for explaining the test method using address-switching according to one embodiment of the present invention.

Fig. 7 shows timing charts for explaining the test method using enable-switching according to another embodiment of the present invention.

Referring now to Fig. 2, there are shown a readout circuit and the related circuits for carrying out the method embodying the present invention. $Q_5$, $Q_6$ denote transistors of an output stage. $Q_7$ denotes a driver transistor. $Q_8$, $Q_9$ denote transistors of the input stage. These five transistors compose an output buffer OUT, which also acts as an inverter. The multiplexer MPX is composed of NAND gate $NAND_0$, a Schottky barrier diode $D_i$, a resistor $R_1$ and a transistor $Q_8$. Each set of multiplexer is provided for each bit line respectively. A multiplexer and the output buffer compose a readout circuit READOUT. While there are many word lines and bit lines in a PROM, only word lines $W_0$, $W_1$, $W_t$, bit line $\overline{B_0}$ and their related memory cells are shown, as it will be sufficient to illustrate the present invention. When the PROM chip is selected, namely the readout circuit is enabled, the chip-enable signal $\overline{CE}$ applied to inverter INV is of an L level. Thus, the output of the inverter INV is of an H level, resulting in turning off the p-n-p transistor $Q_9$ connected at the output of inverter INV. In addition to this condition, if the NAND gate $NAND_0$ delivers H level to select the bit line $B_0$, the output signal $O_0$ of the output buffer OUT, an inverter, falls to L corresponding to the signal H of the bit line $B_0$. In other words, if the addressed cell is non-conductive, thus the voltage $V_b$ at the common point between $NAND_0$ and diode $D_i$, which voltage is always of the same logic level as the voltage $V_a$ on the bit line $B_0$, is H. The transistors $Q_8$, $Q_7$ and $Q_6$ are conductive and the transistor $Q_5$ is non-conductive resulting in delivering L on the output terminal $O_0$. If the addressed cell is conductive, thus $V_b$ is L, the transistors $Q_8$, $Q_7$ and $Q_6$ are non-conductive and the transistor $Q_5$ is conductive resulting to delivering H on $O_0$.

At the fabrication stage of the PROM, the memory cells which are programmable by a PROM-user at field, are of course non-conductive, while the test cells which are used for testing the programmable unwritten-in cells are made conductive according to a predetermined layout scheme. These test cells have been provided in addition to the field programmable cells, originally for testing the peripheral circuits installed in the chip of PROM. Details of testing the peripheral circuits in a PROM by using written-in test cells were disclosed by the inventors et al. in the US Patent No.4320507, "FIELD PROGRAMMABLE DEVICE HAVING TEST PROVISIONS FOR FAULT DETECTION", filed Nov. 19, 1979 and the US Patent No. 4429388, "FIELD PROGRAMMABLE DEVICE WITH INTERNAL DYNAMIC TEST CIRCUIT", filed Dec. 8, 1980. In Fig. 2, $M_t$ denotes a written-in, conductive, test cell. $W_t$ denotes a word line operatively connecting bases of stopper transistors of the test cells. As a simple example of the layout scheme of the written-in test cells, all the cells connected to the single word line $W_t$ may be written-in.

When the written-in memory cell $M_t$ is addressed, the voltage $V_a$ of the bit line $B_0$ becomes L level (the value denoted as $V_L$), namely approximately 1.2V, which is the voltage drop across the conductive transistor of the written-in cell. The value 1.2V is the sum of approximately O.5V, an addressing level, delivered by the decoder/driver D/D and approximately O.7V, the base-emitter voltage drop $V_{BE}$ of the stopper transistor. The voltage $V_a$ is produced by the current flowing from the power source $V_{cc}$ through the resistor $R_1$ and the diode $D_i$. Then, the voltage $V_b$ is 1.6V which is O.4V (the forward drop $V_F$ of the diode $D_i$) higher than that of $V_a$. However, this 1.6V of $V_b$ is not high enough to make the transistors $Q_8$, $Q_7$ and $Q_6$ conductive,

because the threshold voltage to trigger the transistor $Q_8$ is approximately 1.9V which is the sum of each base-emitter voltage necessary to begin to make each of these three transistors conductive. At this state, the output $O_0$ is H. When the unwritten-in cell $M_0$ is addressed, no current flows into the bit line $B_0$, resulting in reduced current flowing through the resistor $R_1$. Then, this reduced current produces a reduced voltage drop across the resistor $R_1$, thus the voltage $V_b$ rises up as high as approximately 2.1V, which is the sum of the three base-emitter voltage drops receiving the current from the resistor $R_1$, and is clamped at this voltage. So, the voltage $V_a$ is 1.7V, an H level (the value denoted as $V_H$), which is $V_b$ less 0.4V ($= V_F$), and the transistors $Q_8$, $Q_7$ and $Q_6$ are conductive, resulting in L on the output terminal $O_0$. Variation of the voltage $V_a$ of the bit line $B_0$ by time, a transient voltage against time, is illustrated in Fig. 3. If the written-in test cell $M_t$ has been addressed, the voltage $V_a$ of the bit line $B_0$ is $V_L$. Then, at this state, if the addressed cell is switched to the programmable unwritten-in cell $M_0$, the $V_a$ starts to rise uo to $V_H$. If the addressed cell is a normal cell having sufficiently little leakage, the rising up of the $V_a$ is as fast as shown by the curve $C_1$. However, if the cell is faulty, showing a leakage, the rising-up is slow, or delayed, as shown by the curve $C_2$, which means a long access time. (If the leakage is very large there is no voltage rising up and the faulty cell is not distinguished from a written-in cell.) Therefore, a faulty cell having a long access time caused by its leakage can be discriminated by checking the voltage level of $V_a$ in comparison with a predetermined threshold level, for example $V_0$ in Fig.3, measured at a predetermined moment $T_s$, for example 50 ns after the signal to switch the cell-addressing is applied. In Fig.3, the curve $C_1$ passing beyond $V_0$ at $T_s$ means "normal", and the curve $C_2$ passing below $V_0$ at the same moment means "faulty". Practical ways of checking the delay are hereinafter described using timing charts in some detail.

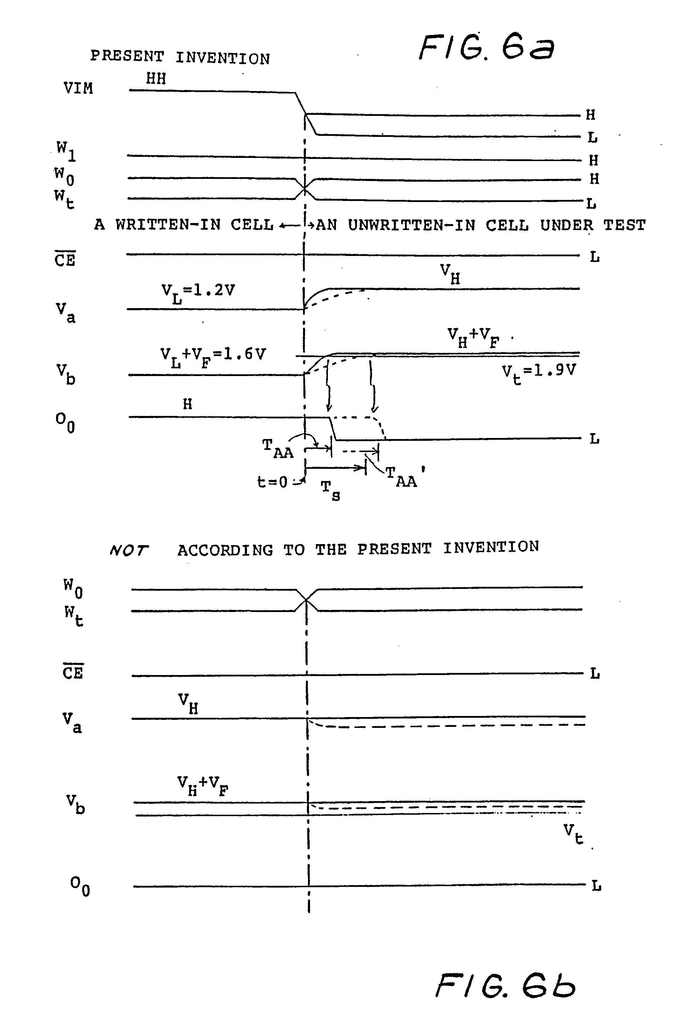

Referring to Fig. 6, the functions of the testing method are described in more detail. Fig. 6a illustrates timing charts of address-switching from a written-in cell to an unwritten-in cell according to the present invention. Fig. 6b illustrates timing charts of address-switching from an unwritten-in cell to another unwritten-in cell, i.e. not according to the present invention. As for Fig. 6a, application of the signal VIM inhibits all the field programmable unwritten-in cells while addressing a word line or a bit line which accesses written-in test cells. The signal VIM has three levels L, H and HH. The HH is 10V, for example. Function of the signal VIM will not be discussed further in detail because it is not essential to describe the present invention, but the details are disclosed by the inventors et al. in the Japanese Patent No. 1217316, "Logic Circuit for Test Bit Selection" registered July 17, 1984, (the examined patent publication No. Toku-58-053440, Nov. 29, 1983). A written-in test cell has been addressed until a moment (defined as $t = 0$), (referred to hereinafter as a first moment) shown by a chain line, at which moment the addressing is switched so as to access an unwritten-in cell. When a written-in cell is addressed, the signal $V_a$ on its bit line $B_0$ is $V_L$, the signal $V_b$ is $V_L + V_F$, and the output signal $O_0$ is H. At the steady state after an unwritten-in cell is addressed, the signal $V_a$ on the bit line is $V_H$, the signal $V_b$ is $V_H + V_F$ and the output signal $O_0$ is L. When the diode of the addressed unwritten-in cell has a leakage, the signal $V_a$ rises as shown by a dotted line more slowly than that of the normal cell shown by a solid line. When the signal $V_b$, having a same trend as $V_a$, reaches the threshold level $V_t$, the output signal $O_0$ falls from H to L. Thus, the moment, denoted as the second moment, at which the output signal falls to L is detected and measured by the external tester. The delay of this second moment with regard to the first moment at which the address pulse is applied to the written-in cell is called the access time, or $t_{PHL}$. In Fig.6a, the normal access time is defined by the moment at which the solid line of a normal cell reaches $V_t$, the time $t_{AA}$. The access time of a leaky cell is defined by the moment at which the dotted line reaches $V_t$, the time $t_{AA}'$. Thus, the access time is easily detected and measured by an external tester, so that the access time can be specified in the test terms in order to discriminate a faulty cell.

There is another way to specify the delay of the access time as an alternative to the above-mentioned method. In this alternative, logic level H or L of the signal $V_b$ at a specified moment $T_s$ is specified, in comparison with the threshold level $V_t$ ($= 1.9V$) at which the transistor $Q_8$ turns from "non-conductive" to "conductive" as mentioned before. The logic level L or H of signal $V_b$ is correspondingly converted to the logic level H or L of the output terminal $O_0$ and can accordingly also be detected by an external tester. Namely, the buffer $\overline{\text{OUT}}$ acts also as a comparator. Therefore, the logic level of the output terminal $O_0$ at a predetermined time $\overline{T_s}$ in Fig. 6a can be specified in the test terms in order to discriminate a faulty cell. The smaller the value of $T_s$, the smaller the checked delay time of the cell.

On the other hand, all the user-programmable cells are, of course, unwritten-in until they are eventually written-in by a user. Therefore, without using a written-in cell, if the address switching is done from an unwritten-in cell $M_0$ to another unwritten-in cell $M_1$, the voltage $V_a$ of the bit line $B_0$ remains essentially the same, or changes much less than in the case of the test performed according to the present invention. Namely, if the cells are not leaky at all, the voltage is kept at the same value $V_H$, and if the newly addressed cells are leaky, the voltage drop determined by the value of the leakage is observed as shown by the dotted lines in Fig. 6b. However, the voltage drop affected on $V_b$ is not large enough to trigger the output circuit OUT. So, discriminating of a faulty cell is difficult. However, in contrast with this difficulty in discriminating faulty cells, the use of a written-in cell according to the method of the present invention, enables the production of evident changes in the voltages $V_a$ and $V_b$, as above-described. Therefore, when the addressing of the written-in cell and unwritten-in cell is switched, reliable discriminating of the faulty cells can be achieved.

There is another way of performing address switching. Namely, at first, the readout circuit READOUT, composed of the multiplexer MPX and the output buffer OUT, is disabled; at second, the addressing is switched from a written-in cell to an unwritten-in cell to be tested; at third, the readout circuit is enabled; at fourth, the delay of output signal from the moment of applying the address switching pulse is measured. Comparison to this embodiment of the method according to the invention with the above described first embodiment is shown in the following table for easier understanding

## METHODS OF ADDRESS SWITCHING

| steps | - - first method - - | | - - second method - - | |
|---|---|---|---|---|
| | | output | | output |
| *chip-enable | enabled | - | disabled | - |
| *addressing | writt. cell | - | writt. cell | - |
| *address- | | | | |
| switching to | unwritt. cell | changes | unwritt. cell | - |
| *chip-enable | same | - | enabled | changes |

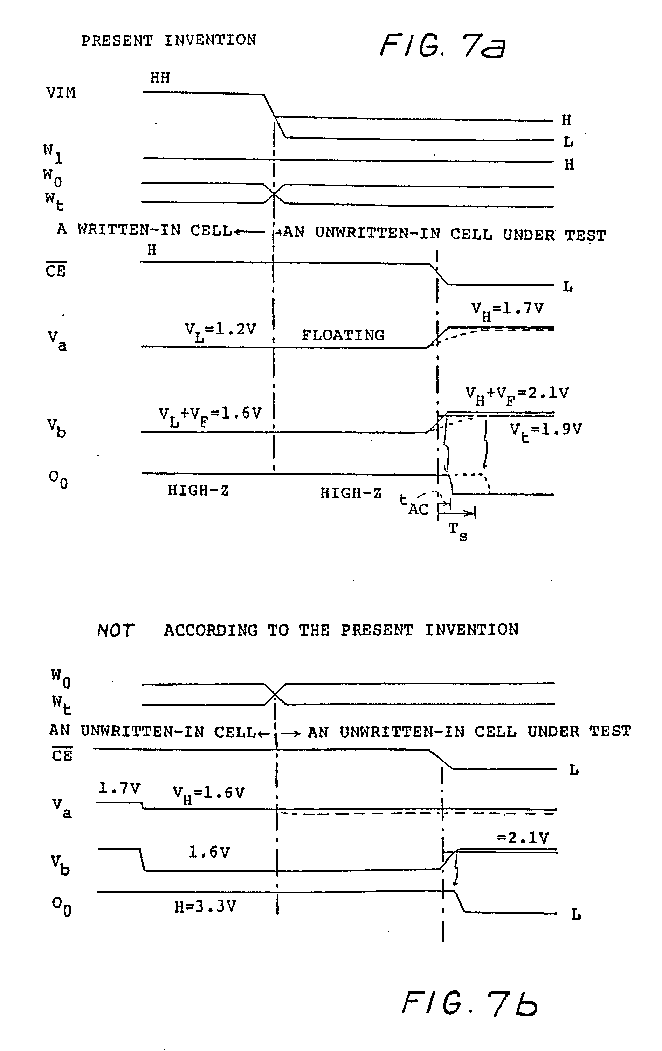

Referring to Fig.2, the function of the chip-enable signal is explained first. When the chip-enable signal $\overline{CE}$ is H, meaning chip-disabling, the output of the inverter INV is L, so that the transistor $Q_9$ is conductive, the transistor $Q_5$ is non-conductive and the emitter of the transistor $Q_8$ is clamped to the L level of the inverter INV through the diode $D_j$. Accordingly, the transistors $Q_7$ and $Q_6$ are non-conductive, and, therefore, the state of the output terminal $O_0$ is high-Z (a high impedance). In other words, the transistors $Q_5$, $Q_6$ operatively connected to the output terminal $O_0$ are both non-conductive, keeping the output terminal floating. (The output level is determined only by external circuits operatively connected to this terminal $O_0$.) This type of circuit is called a tri-state structure, delivering H, L and high-Z. At the high-Z state, the voltage $V_b$ is 1.6V, which is the sum of 0.5V (L level of INV out), 0.4V (forward drop $V_F$ of the diode $D_j$) and 0.7V ($V_{BE}$ of transistor $Q_8$). Further, at this state, if a written-in cell $M_t$ is addressed, its bit line voltage is 1.2V, which is equivalent 1.6V ($V_b$) less 0.4V ($V_F$). While the readout circuit is disabled, if an unwritten-in normal cell is addressed, its bit line $B_0$ becomes floating, because the voltage $V_b$ is kept pulled down to 1.6V by L of the INV output through $D_j$ and $V_{BE}$ of transistor $Q_8$, letting the diode $D_i$ be non-conductive. However, if the unwritten-in normal cell is addressed successively after addressing a written-in cell, the bit line $B_0$ holds the voltage 1.2V of the previous state, that is addressing the written-in cell, because the voltage is held by the charge of the stray capacity $C_0$ of the bit line. At this state when an unwritten-in cell has been addressed, if the readout circuit is switched so as to be enabled by applying a chip-enable signal $\overline{CE}$ at level L, the H output of the INV turns off the transistor $Q_9$ as well as pushes the voltage $V_b$ up to 2.1V through diode $D_j$ and transistor $Q_8$. Thus the voltage $V_a$ rises up to $V_H$, 1.7V, which is $V_b$ less $V_F$. However, if the cell is leaky, the voltages $V_a$ and $V_b$ rise slowly, as shown by the dotted lines in Fig. 7a and Fig.3, and, accordingly, the falling of the output $O_0$ from H to L is delayed as shown also by a dotted line. Using an external tester, this moment of the falling of the output signal can be measured as an access delay time from the moment of applying the enable signal pulse $\overline{CE}$. This delay time is called chip-enable access time, $t_{AC}$ or delay from high Z to L, $t_{PZL}$, and specified in the test specification. This access delay can also be checked by reading signal level H or L of the output terminal $O_0$ at a predetermined time $T_s$. The shorter $T_s$ corresponds to the smaller leakage. Accordingly, $T_s$ is a test condition in a specification to check a faulty cell caused by its degraded isolation.

In a case not according to the present invention, where addressing is at first switched from an unwritten-in cell to another unwritten-in cell and successively the readout circuit is switched from "disable" to "enable", the voltage $V_b$ is 1.6V, and the voltage $V_a$ is also approximately 1.6V, because this value was

6

1.7V in the previous enabled state and now the voltage drop $D_F$ of the diode $D_i$ is nearly zero or reversely biased. The voltage $V_a$ is determined by the amount of the leak, as shown by the dotted line in Fig. 7b. At this stage, if the readout circuit is enabled, the voltage $V_b$ can rise up to 2.1V quickly, whereas the voltage $V_a$ rises up from 1.6V to only 1.7V. Accordingly, it is very difficult to detect a faulty cell by detecting the difference in the rising voltage.

An advantage of the above-described second embodiment using "enabling" of the readout circuit over the first embodiment using only address-switching is that the applied voltage difference upon the unwritten cell is certainly obtained by "enabling" the readout circuit after address switching is completed. In the first embodiment, the voltage $V_a$ on the written-in cell may rise for some degree while the addressing is passing other cells before reaching an unwritten-in cell of destination. This unexpected voltage rise of $V_a$ causes less voltage difference applied on the unwritten-in cell to be tested, resulting in a less sensitive detection of a faulty cell. However, in the second embodiment, the address switching is carried out, without voltage being supplied to the bit line during the "disabling" period. Thus, the voltage difference is always secured.

The specified test condition is very equivalent to the practical application. Access time of the normal cells are distributing below 50 ns, however, faulty cells having small leakage are distributed near 70 ns in group, which proves that the sorting of the faulty cell is achieved easily and reliably. The written-in cells have been previously provided in the PROM cells for testing the peripheral circuits therein as cited above. Therefore, no additional provision of written-in cell or of circuit is required in the chip or in the external test equipment for the test according to the present invention, but only some addition of test programming is required. Accordingly, the cost increase for embodying the present invention is almost nothing. However, according to the present invention, a leaky cell which causes access delay but could not be detected by the prior art is quite easily and quite reliably detected, resulting in an improvement of quality control in the factory and also an improvement of writing-in ratio at field.

Although the above description has been made with reference to a junction-shortening type PROM, it is apparent that the invention can be carried out on PROMs of other types, such as of fuse-blown type, insulator-shortening type and others. Other modifications can be made to the above described embodiments without departing from the scope of protection. For example, instead of performing the address switching from a written-in cell to an unwritten-in cell, the address-switching from an unwritten-in cell to a written-in cell is also possible according to the present invention, when a different kind of peripheral readout circuit, such as for reading-out the word lines, is used.

In addition, although the address switching is described hereinabove on a single bit line, it may be performed, according to the present invention, between different bit lines. It is because the memory cells on a single word line can be all written-in cells, as on the test word line shown in Fig. 2 and 4, that the voltage $V_a$ on all the bit lines can be simultaneously pulled down to 1.2V. The same applies in the case of a single bit line with all the memory cells operatively connected thereto being written-in, as shown in Fig. 4.

Further, although in the above description the address-switching and enable-switching are both initiated by external signals, it is apparent that, according to the present invention, these switching operations can be initiated automatically by using a built-in circuit or built-in program on the chip, respectively.

Still further, instead of having a readout circuit in the form of a buffer acting also as a comparator/inverter, it is apparent that at least one of or a combination of a comparator, an inverter, an amplifier or a flip-flop can be used for forming the readout circuit.

Still further, instead of carrying out the detection of the variation of the bit line at the output terminal of the readout circuit, said detection can be carried out by measuring the voltage of inner circuits by means of probes. In this case, the threshold level can be specified independently from the threshold level of the readout circuit.

Finally, it may be noted that the detection of variation of voltage in the testing method according to the invention can be carried out at an output terminal of the device through at least one of the comparators which convert said varying voltage of an analogue signal to a digital output signal, whereby said variation of voltage is measured digitally by an external testing means.

## Claims

1. A method for testing a programmable semiconductor device having unwritten-in cells ($M_0, M_1$) for field-programming as well as previously written-in cells ($M_t$) for test, said method being characterized in that it includes the steps of:

   (a) switching the state of one of the written-in cells ($M_t$) and the state of one of the unwritten-in cells ($M_0, M_1$) to be tested for a line ($B_0$);

   (b) detecting variation of voltage ($V_a$) associated with said switching (a) on that line ($B_0$); and

(c) comparing said detected value ($V_a$) with a predetermined specification value ($V_o$), whereby the unwritten-in cell is determined to be normal or faulty.

2. A method according to claim 1, characterized in that said switching cited in said step (a) is carried out by firstly selecting the written-in cell and secondly selecting the unwritten-in cell.

3. A method according to claim 1, characterized in that said switching cited in said step (a) is carried out by firstly selecting the unwritten-in cell and secondly selecting the written-in cell.

4. A method according to claim 1, wherein the programmable semiconductor device comprises a readout circuit which is provided for sensing a state of a selected cell, characterized in that said variation of voltage cited in said step (b) is made available by said cell switching cited in said step (a) while enabling said readout circuit.

5. A method according to any one of claims 2 and 3, characterized in that said switching is carried out by changing address input signals for addressing a cell.

6. A method according to claim 1, characterized in that said voltage cited in said step (b) is a voltage on a bit line of a cell selected by said step (a).

7. A method according to claim 1, characterized in that said voltage cited in said step (b) is a voltage on a word line of a cell selected by said step (a).

8. A method according to claim 1, wherein the programmable semiconductor device comprises a readout circuit which is provided for sensing a state of a selected cell, characterized in that said variation of voltage cited in said step (b) is unavailable while said readout circuit is disabled, and is made available by enabling said readout circuit.

9. A method according to claim 8, characterized in that the enabling of the readout circuit is carried out by a chip-enable signal which enables as well as disables the output of the device.

10. A method according to claim 1, characterized in that said detection of variation of voltage cited in said step (b) is carried out by measuring said voltage level a predetermined time after said variation of voltage starts.

11. A method according to claim 1, characterized in that said detection of variation of voltage cited in said step (b) is carried out by measuring a delay time at which said voltage reaches a predetermined threshold voltage, said delay time being measured after a moment at which said voltage variation starts.

12. A method according to any one of claims 10 and 11, characterized in that a moment at which said variation of voltage starts is defined by a moment at which said switching cited in said step (a) is initiated.

13. A method according to claims 4 and 10, or 8 and 10, or 4 and 11, or 8 and 11, characterized in that said moment at which said variation of voltage starts is defined by a moment at which said "enabling said readout circuit" is initiated.

14. A method according to any one of claims 10 to 13, characterized in that the detection of variation of voltage is carried out at an output terminal of the device through at least one of comparators which convert said varying voltage of an analogue signal to a digital output signal, whereby said variation of voltage is measured digitally by an external testing means.

**Revendications**

1. Procédé de test d'un dispositif à semiconducteur programmable possédant des cellules non écrites ($M_0$, $M_1$) destinées à être programmées sur place par l'utilisateur ainsi que des cellules précédemment écrites ($M_t$) destinées au test, ledit procédé étant caractérisé en ce qu'il comporte les opérations suivantes :

8

(a) faire commuter l'état d'une des cellules écrites ($M_t$) et l'état d'une des cellules non écrites ($M_0$, $M_1$) à tester sur une ligne ($B_0$) ;

(b) détecter la variation de tension associée à ladite commutation (a) sur cette ligne ($B_0$) ; et

(c) comparer ladite valeur détectée ($V_a$) avec une valeur de spécification prédéterminée ($V_0$), de façon à déterminer que la cellule non écrite est normale ou défectueuse.

2. Procédé selon la revendication 1, caractérisé en ce qu'on effectue ladite commutation indiquée à ladite opération (a) en commençant par sélectionner la cellule écrite, puis en sélectionnant la cellule non écrite.

3. Procédé selon la revendication 1, caractérisé en ce qu'on effectue ladite commutation indiquée à ladite opération (a) en commençant par sélectionner la cellule non écrite, puis en sélectionnant la cellule écrite.

4. Procédé selon la revendication 1, où le dispositif à semiconducteur programmable comprend un circuit de lecture qui est conçu pour pouvoir détecter l'état d'une cellule sélectionnée, caractérisé en ce que ladite variation de tension indiquée à ladite opération (b) est rendue disponible par ladite commutation de cellule indiquée à ladite opération (a) pendant la validation dudit circuit de lecture.

5. Procédé selon l'une quelconque des revendications 2 et 3, caractérisé en ce qu'on effectue ladite commutation en changeant les signaux d'entrée d'adressage destinés à adresser une cellule.

6. Procédé selon la revendication 1, caractérisé en ce que ladite tension indiquée à ladite opération (b) est la tension présente sur une ligne de bit d'une cellule sélectionnée par ladite opération (a).

7. Procédé selon la revendication 1, caractérisé en ce que ladite tension citée à ladite opération (b) est la tension présente sur une ligne de mot d'une cellule sélectionnée par ladite opération (a).

8. Procédé selon la revendication 1, où le dispositif à semiconducteur programmable comprend un circuit de lecture qui est conçu pour détecter l'état d'une cellule sélectionnée, caractérisé en ce que ladite variation de tension indiquée à ladite opération (b) n'est pas disponible pendant que ledit circuit de lecture est invalidé, et est rendue disponible par validation dudit circuit de lecture.

9. Procédé selon la revendication 8, caractérisé en ce qu'on effectue la validation du circuit de lecture au moyen d'un signal de validation de puce qui valide aussi bien qu'invalide le signal de sortie du dispositif.

10. Procédé selon la revendication 1, caractérisé en ce qu'on effectue ladite détection de la variation de tension indiquée à ladite opération (b) en mesurant le niveau de ladite tension un temps prédéterminé après que ladite variation de tension a commencé.

11. Procédé selon la revendication 1, caractérisé en ce qu'on effectue ladite détection de la variation de tension indiquée à ladite opération (b) en mesurant le temps de retard auquel ladite tension atteint une tension de seuil prédéterminée, ledit temps de retard étant mesuré à partir du moment où ladite variation de tension a commencé.

12. Procédé selon l'une quelconque des revendications 10 et 11, caractérisé en ce que le moment auquel ladite variation de tension commence est défini par le moment auquel ladite commutation indiquée à ladite opération (a) a été déclenchée.

13. Procédé selon les revendications 4 et 10, ou 8 et 10, ou 4 et 11, ou 8 et 11, caractérisé en ce que ledit moment auquel ladite variation de tension commence est défini par le moment où ladite "validation dudit circuit de lecture" a commencé.

14. Procédé selon l'une quelconque des revendications 10 à 13, caractérisé en ce qu'on effectue la détection de la variation de tension sur une borne de sortie du dispositif par l'intermédiaire d'au moins l'un de plusieurs comparateurs qui convertissent ladite tension variable d'un signal analogique en un signal de sortie numérique, si bien que ladite variation de tension est mesurée numériquement par un moyen de test externe.

**Patentansprüche**

1. Verfahren zum Testen einer programmierbaren Halbleitervorrichtung, die unbeschriebene Zellen ($M_0$, $M_1$) zur Feldprogrammierung sowie vorher beschriebene Zellen ($M_t$) zum Test enthält, wobei das Verfahren dadurch gekennzeichnet ist, daß es folgende Schritte umfaßt:
   (a) Schalten des Zustands einer der beschriebenen Zellen ($M_t$) und des Zustands einer der auf einer Leitung ($B_0$) zu testenden, unbeschriebenen Zellen ($M_0$, $M_1$);
   (b) Messen der mit dem Schalten (a) verbundenen Spannungsänderung ($V_a$) auf der Leitung ($B_0$); und
   (c) Vergleichen des Meßwertes ($V_a$) mit einem vorher festgelegten Spezifikationswert ($V_0$), wodurch die unbeschriebene Zelle als normal oder fehlerhaft bestimmt wird.

2. Verfahren nach Anspruch 1, dadurch gekennzeichnet, daß das in dem Schritt (a) aufgeführte Schalten durchgeführt wird, indem zuerst die beschriebene und danach die unbeschriebene Zelle selektiert wird.

3. Verfahren nach Anspruch 1, dadurch gekennzeichnet, daß das in dem Schritt (a) aufgeführte Schalten durchgeführt wird, indem zuerst die unbeschriebene und danach die beschriebene Zelle selektiert wird.

4. Verfahren nach Anspruch 1, bei dem die programmierbare Halbleitervorrichtung einen Ausleseschaltkreis umfaßt, welcher zum Erfassen des Zustands einer selektierten Zelle vorgesehen ist, dadurch gekennzeichnet, daß die in dem Schritt (b) aufgeführte Spannungsänderung durch das in dem Schritt (a) aufgeführte Schalten verfügbar gemacht wird, solange der Ausleseschaltkreis aktiviert ist.

5. Verfahren nach Anspruch 2 oder 3, dadurch gekennzeichnet, daß das Schalten durch Änderung der Adress-Eingangssignale zur Adressierung einer Zelle durchgeführt wird.

6. Verfahren nach Anspruch 1, dadurch gekennzeichnet, daß die in dem Schritt (b) aufgeführte Spannung eine Spannung auf einer Bitleitung einer durch den Schritt (a) selektierten Zelle ist.

7. Verfahren nach Anspruch 1, dadurch gekennzeichnet, daß die in dem Schritt (b) aufgeführte Spannung eine Spannung auf einer Wortleitung einer durch den Schritt (a) selektierten Zelle ist.

8. Verfahren nach Anspruch 1, bei dem die programmierbare Halbleitervorrichtung einen Ausleseschaltkreis umfaßt, der zum Erfassen des Zustands einer selektierten Zelle vorgesehen ist, dadurch gekennzeichnet, daß die in dem Schritt (b) aufgeführte Spannungsänderung nicht verfügbar ist, während der Ausgabeschaltkreis nicht aktiviert ist und durch Aktivieren des Ausgabeschaltkreises verfügbar gemacht wird.

9. Verfahren nach Anspruch 8, dadurch gekennzeichnet, daß die Aktivierung des Ausleseschaltkreises durch ein Chip-Aktivierungssignal durchgeführt wird, das die Ausgabe der Vorrichtung sowohl aktiviert als auch deaktiviert.

10. Verfahren nach Anspruch 1, dadurch gekennzeichnet, daß die Messung der in dem Schritt (b) aufgeführten Spannungsänderung durchgeführt wird durch Messung des Spannungspegels zu einem vorbestimmten Zeitpunkt nach dem Anfang der Spannungsänderung.

11. Verfahren nach Anspruch 1, dadurch gekennzeichnet, daß die Messung der in dem Schritt (b) aufgeführten Spannungsänderung duchgeführt wird durch Messung einer Verzögerungszeit, zu der die Spannung eine vorbestimmte Schwellenspannung erreicht, wobei diese Verzögerungszeit nach einem Zeitpunkt, an dem die Spannungsänderung beginnt, gemessen wird.

12. Verfahren nach einem der Ansprüche 10 und 11, dadurch gekennzeichnet, daß der Zeitpunkt, an dem die Spannungsänderung beginnt, definiert ist durch einen Zeitpunkt, zu dem das in dem Schritt (a) aufgeführte Schalten begonnen wird.

13. Verfahren nach den Ansprüchen 4 und 10, oder 8 und 10, oder 4 und 11, oder 8 und 11, dadurch gekennzeichnet, daß der Zeitpunkt, an dem die Spannungsänderung beginnt, definiert ist durch einen Zeitpunkt, zu dem die "Aktivierung des Ausleseschaltkreises" begonnen wird.

14. Verfahren nach einem der Ansprüche 10 bis 13, dadurch gekennzeichnet, daß die Messung der Spannungsänderung an einem Ausgabeanschluß der Schaltung vorgenommen wird durch mindestens einen von Komparatoren, die die veränderliche Spannung von einem analogen Signal in ein digitales Ausgabesignal umwandeln, wodurch die Spannungsänderung durch ein externes Testmittel digital gemessen wird.

FIG. 1a

FIG. 1c

FIG. 1b

FIG.3

FIG.2

BLOCK DIAGRAM OF A PROM

FIG. 4

FIG.5

FIG. 6a

PRESENT INVENTION

A WRITTEN-IN CELL ←─┤→AN UNWRITTEN-IN CELL UNDER TEST

NOT ACCORDING TO THE PRESENT INVENTION

FIG. 6b

PRESENT INVENTION

*FIG. 7a*

VIM — HH ... H / L

$W_1$ — H

$W_0$

$W_t$

A WRITTEN-IN CELL ← → AN UNWRITTEN-IN CELL UNDER TEST

$\overline{CE}$ — H ... L

$V_a$ — $V_L = 1.2V$ — FLOATING — $V_H = 1.7V$

$V_b$ — $V_L + V_F = 1.6V$ — $V_H + V_F = 2.1V$ / $V_t = 1.9V$

$O_0$ — HIGH-Z — HIGH-Z — $t_{AC}$ — $T_s$

*NOT* ACCORDING TO THE PRESENT INVENTION

$W_0$

$W_t$

AN UNWRITTEN-IN CELL ← → AN UNWRITTEN-IN CELL UNDER TEST

$\overline{CE}$ — L

$V_a$ — 1.7V — $V_H = 1.6V$

$V_b$ — 1.6V — = 2.1V

$O_0$ — H = 3.3V — L

*FIG. 7b*